Europäisches Patentamt

European Patent Office

Office européen des brevets

(11) Numéro de publication: **0 061 970**
**B1**

(12)

# FASCICULE DE BREVET EUROPEEN

(45) Date de publication du fascicule du brevet:
**27.12.84**

(21) Numéro de dépôt: **82400540.9**

(22) Date de dépôt: **25.03.82**

(51) Int. Cl.³: **B 60 J 1/17,** E 05 F 15/00,
H 03 K 17/955

(54) Fenêtre coulissante à commande électrique et détecteur de proximité.

(30) Priorité: **25.03.81 DE 3111724**

(43) Date de publication de la demande:
**06.10.82 Bulletin 82/40**

(45) Mention de la délivrance du brevet:
**27.12.84 Bulletin 84/52**

(84) Etats contractants désignés:
**BE DE FR GB IT SE**

(56) Documents cités:
**DE - A - 1 690 298**
**DE - A - 2 939 942**
**FR - A - 2 073 975**
**US - A - 3 651 389**

(73) Titulaire: **SAINT-GOBAIN VITRAGE, Les
Miroirs 18, avenue d'Alsace, F-92400 Courbevoie (FR)**
(84) Etats contractants désignés: **BE FR GB IT SE**

(73) Titulaire: **VEGLA Vereinigte Glaswerke GmbH, Viktoria
Allee 3-5, D-5100 Aachen (DE)**
(84) Etats contractants désignés: **DE**

(72) Inventeur: **Sauer, Gerd, Heinrich Hamacher Weg 11,
D-5120 Stolberg-Venwegen (DE)**
Inventeur: **Unbehaun, Dieter, Kobergerstrasse 58,
D-8500 Nuernberg (DE)**

(74) Mandataire: **Breton, Jean-Claude et al, SAINT-GOBAIN
RECHERCHE 39, quai Lucien Lefranc,
F-93300 Aubervilliers Cedex (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit
être formée par écrit et motivée. Elle n'est réputée formée qu'après paiement de la taxe d'opposition (Art. 99(1) Convention sur le
brevet européen).

## Description

L'invention a trait à une fenêtre coulissante destinée en particulier à des véhicules automobiles, mue électriquement et munie d'un dispositif de sécurité obéissant à un détecteur de proximité. Ce dispositif comprend un circuit électronique dans lequel un conducteur disposé le long du bord supérieur de la vitre constitue le capteur capacitif d'un étage de détection à oscillateur et commande un relais de coupure interrompant l'alimentation électrique du moteur au-delà d'un certain seuil d'amortissement.

Le brevet US 3 651 389 décrit une fenêtre de ce type dont le circuit de commande, constitué d'éléments électroniques discrets, forme, en raison des dimensions de ces derniers, un ensemble relativement encombrant, qui doit être mis en place à poste fixe, à l'intérieur de la porte, par exemple au voisinage du moteur d'entraînement. La haute sensibilité recherchée pour que le dispositif réponde même au contact d'une pièce de vêtement, un gant par exemple, oblige à le raccorder au capteur disposé sur la vitre à l'aide d'un conducteur blindé, en particulier un câble coaxial.

Entre la feuille de verre mobile d'une part et le circuit de commande fixe d'autre part, ce câble de liaison revêt alors commodément la forme d'un câble suspendu, fixé exclusivement à ses deux bornes de raccordement et, pour le reste, oscillant librement à l'intérieur du caisson de porte lorsqu'on déplace la vitre, que l'on claque la portière ou en d'autres occasions.

Un tel type de construction a plusieurs inconvénients. Ainsi, par exemple, il n'existe aucune garantie qu'une erreur de montage ne conduise à placer sur le véhicule un boîtier inadapté. Il est en effet nécessaire, en raison de sa grande sensibilité, d'ajuster le dispositif à la résistance ohmique et à la capacité du capteur pour éviter tout ennui de fonctionnement, réglage qui dépend essentiellement de la forme et des dimensions de la vitre et du cadre de la fenêtre, de sorte qu'il suffit d'y pourvoir en fonction du type de véhicule; ainsi les circuits ne peuvent s'échanger indifféremment: si l'on monte sur un véhicule un dispositif de commande conçu pour un véhicule d'un autre type, le point de réglage est généralement incorrect, donc le fonctionnement défectueux.

Le raccordement du capteur au circuit par un câble blindé suspendu constitue une autre source de défauts. De tels câbles sont relativement rigides et, sous l'effet des flexions continuelles provoquées par la levée et la descente de la vitre, ils exercent sur leurs connexion des efforts excessifs qui, à la longue, conduisent facilement à la rupture de l'une ou l'autre d'entre elles. Enfin, ils n'apportent pas une sécurité absolue contre des couplages parasites car ils se déplacent de façon plus ou moins incontrôlée à l'intérieur du caisson où ils se trouvent, et où en règle générale, pénètre de l'eau ou du moins de l'humidité, qui peut aussi provoquer des variations de capacité capables de faire fonctionner intempestivement le dispositif de sécurité.

L'invention a pour objet de perfectionner les fenêtres de véhicules à entraînement électrique munies d'un dispositif de sécurité du type défini plus haut, de façon à réduire les perturbations et à atteindre un degré maximal de sûreté de fonctionnement.

Selon l'invention, on dispose à même la vitre qui porte le capteur, et en position fixe l'un par rapport à l'autre, aussi bien l'élément de circuit comprenant l'étage de détection que la ligne de liaison entre cet élément et le capteur. Dans ce but, l'élément de circuit en question est un élément compact, avantageusement construit sous la forme d'un circuit intégré.

L'invention élimine les inconvénients inhérents à technique antérieure. L'élément de circuit compact comprenant l'étage de détection peut être fixé directement sur les vitres par enfichage, collage, voire soudage dans l'atelier de fabrication de ces dernières, ce qui élimine quasi totalement les risques de confusion. Le danger de rupture du câble de connexcion est totalement exclu, et supprimée la naissance de signaux parasites par suite de ses déplacements incontrôlés.

L'invention présente aussi des avantages notables sur le plan des techniques de fabrication et du prix de revient, de sorte qu'elle améliore à de nombreux égards la construction des fenêtres équipées de cette sécurité.

Des dispositions avantageuses et des développements de l'invention ressortent de la description ci-dessous d'exemples préférés, faite en liaison avec les dessins, qui montrent:

figure 1 sous forme d'une vue d'ensemble, une première version d'une fenêtre de véhicule conforme à l'invention;

figure 2 toujours sous forme d'une vue d'ensemble, une autre version de la nouvelle fenêtre;

figure 3 une coupe selon la ligne III.III de la figure 1;

figure 4 une coupe selon la ligne IV.IV de la figure 2;

figure 5 un détail, vu en coupe, d'une fenêtre de véhicule porteuse d'une bande conductrice recouverte d'une couche de protection céramique;

figure 6 un détail du bord d'une fenêtre de véhicule conforme à l'invention présentant une disposition différente et une autre structure de contacts finals;

figure 7 une coupe selon la ligne VII.VII de la fenêtre de la figure 6;

figure 8 une nouvelle variante de fenêtre conforme à l'invention, dont la vitre porte plusieurs contacts auxiliaires.

La vitre 1 destinée à former la fenêtre coulissante d'un véhicule, habituellement celle d'une porte de voiture, peut avoir des formes très différentes. En règle générale, elle est à peu près rectangulaire, avec un bord abattu 2 correspondant à la forme de l'ouverture de la fenêtre. Son bord inférieur 3 est pris dans un profil métallique non représenté, sur lequel le moteur d'entraînement de la vitre, qui n'est pas non plus représenté, agit par l'intermédiaire d'une transmission convenable à arbre ou à levier. Le long du bord supérieur 4 et du bord oblique 2 se trouve placé, sur la face interne du vitrage, un conducteur électrique formant un capteur 5. Ce conducteur possède une largeur de l'ordre de 0,4 à 1 mm et une épaisseur de l'ordre de 0,01 à 0,02 mm. Il est normalement constitué d'un émail céramique à chaud, électriquement

2

conducteur, à base d'argent métallique, obtenu à partir d'une pâte pour sérigraphie du commerce.

Le circuit de détection piloté par le capteur pour commander la sécurité se fixe directement, sous forme d'un élément compact 6, sur la face interne de la vitre 1, dans sa partie inférieure qui, même lorsque la fenêtre est fermée, se trouve en dessous du bord de la portière, représenté par la ligne L, et reste donc invisible. Il s'agit d'un circuit intégré monolithique, de sorte que l'élément 6 a des dimensions très faibles, de l'ordre de 60 × 20 × 4 mm.

Le long du bord vertical 7 court la ligne de liaison 8 entre le capteur 5 et l'élément 6, constitué comme le capteur d'une bande céramique conductrice, incorporée par fusion à la surface du verre où elle est déposée puis cuite en même temps que lui. Au voisinage de l'élément 6, elle aboutit à une plage élargie 9, toujours constituée du même matériau et obtenue de la même façon, sur laquelle est soudé le fil de raccordement 9' de cet élément.

La ligne de liaison 8 court à une distance A, de l'ordre de 2 à 4 cm, du bord vertical 7 de la feuille de verre. On réduit ainsi fortement l'influence de la partie du cadre métallique qui emprisonne le bord 7 sur la ligne de liaison 8, et l'on crée en outre entre elle et le bord 7 un espace suffisant pour pouvoir y disposer des plages de contact 11 et 12, respectivement reliées par des lignes 13 et 14 à des plages élargies 15 et 16 d'où elles sont raccordées à l'élément 6 par des fils soudés 15' et 16'. Les plages de contact coopèrent avec des contacts glissants disposés dans le cadre de la fenêtre pour couper l'alimentation de son moteur et débrancher le circuit de détection dans les positions de fin de course supérieure et inférieure de la vitre.

L'élément 6 possède deux fiches de contact 17 pour le raccordement du câble d'alimentation venant de la batterie et deux fiches analogues 18 pour celui du moteur d'entraînement. L'étage de puissance du circuit de commande et son relais sont avantageusement disposés, à postes fixes, à l'intérieur de la porte du véhicule, de préférence sur le moteur ou à son voisinage immédiat.

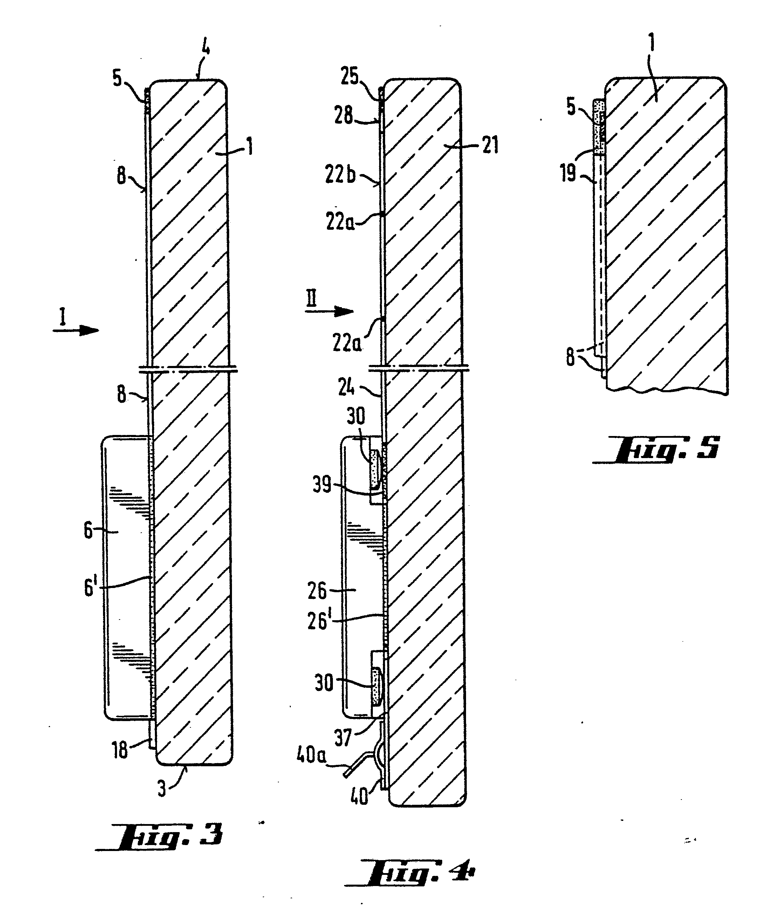

Comme on peut le voir sur la figure 3, l'élément 6 est assemblé de façon solide et durable sur la face interne de la vitre 1, à l'aide d'une couche de colle 6'.

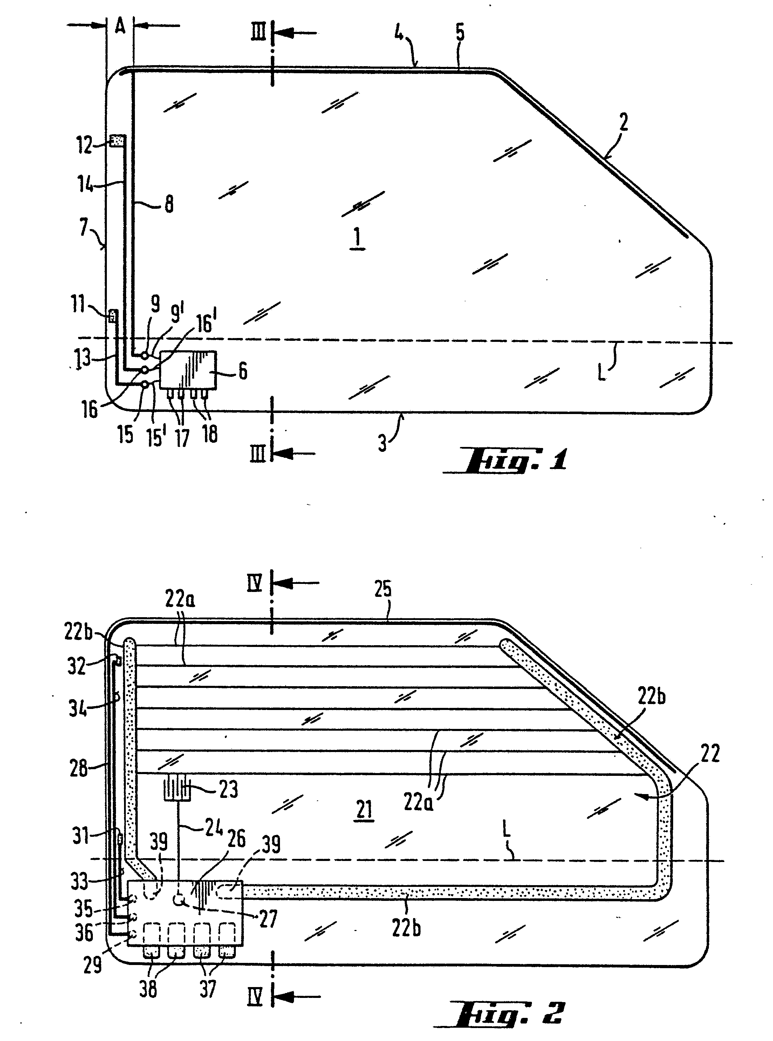

La version représentée par la figure 2 correspond à une fenêtre chauffante à commande automatique. La vitre 21 ne porte donc pas seulement le capteur 25, l'élément de circuit 26 et les conducteurs correspondant à ceux de la figure 1 mais reçoit aussi d'autres conducteurs imprimés: y est ainsi placé un réseau chauffant 22 formé de conducteurs horizontaux 22a débouchant sur des collecteurs latéraux 22b, eux-mêmes raccordés à l'élément de circuit 26 qui les alimente en courant. Un détecteur d'humidité 23 constitué de deux électrodes imbriquées se greffe sous celui des conducteurs 22a qui se trouve le plus bas et se raccorde à l'élément 26 par une ligne 24 aboutissant à une plage élargie 27.

L'élément 26 est un circuit intégré monolithique analogue à l'élément 6, mais il comprend des fonctions de commande supplémentaires pour la mise en route et l'arrêt du réseau chauffant 22. Il peut encore remplir d'autres fonctions comme par exemple celle de donner l'alarme lorsque l'on détruit le vitrage, grâce à un détecteur susceptible d'être lui-même constitué d'une bande conductrice brute, imprimée et cuite à la surface du vitrage, par exemple sous forme d'une boucle qui, se trouvant rompue lors d'une effraction du vitrage, déclenche alors l'émission du signal d'alarme.

La ligne de liaison 28, élargie à son extrémité en une plage 29 est, dans ce cas, disposée entre le collecteur 22b correspondant et le bord vertical de la vitre 21, les lames de contact 31, 32 et leurs lignes de raccordement 33, 34 avec leurs plages de connexion extrêmes 35, 36 dans la zone comprise entre elle et le collecteur.

Les plages de connexion 37 servent à raccorder les câbles conduisant à la batterie, les plages 38, ceux qui alimentent le moteur d'entraînement; sur ces quatre plages 37 et 38 sont soudées des bornes 40 munies de fiches 40a sur lesquelles viendront s'enfiler les cosses de raccordement. Les plages de connexion 39 sur les prolongements des collecteurs 22b servent à alimenter le réseau chauffant.

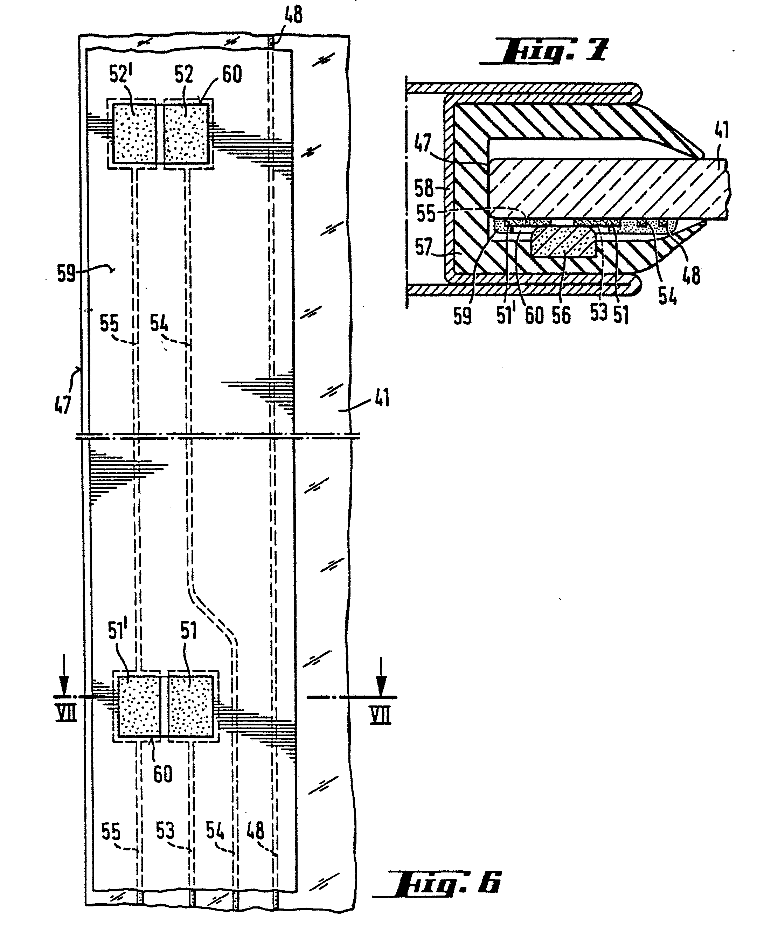

Le boîtier du circuit intégré 26, peut, par exemple, être muni de plots de contact électriques 30 qui viennent appuyer, comme le montre la figure 4, sur les plages de connexion en question. L'élément 26 est ici encore fixé à demeure sur la vitre 21 par une couche de colle 26'. Toutes les parties électroconductrices formant les conducteurs et leurs plages de connexion: capteur 25, lignes de raccordement 28, 33, 34, capteur d'humidité 23 et sa connexion 24, plages 27, 29 et 35 et 39, conducteurs 22a et collecteurs 22b du réseau chauffant 22, sont émaillés à chaud à partir de la même fritte électro-conductrice, imprimée à l'écran de soie en une seule et même opération sur la surface du vitrage puis cuite au cours du réchauffage qui permet de tremper celui-ci.

Le cas échéant, pour protéger les bandes conductrices de la corrosion due à l'humidité ou de la détérioration par des contacts directs, on peut les recouvrir d'une couche d'émail électriquement isolante. Une telle variante, selon laquelle une vitre 1 porte un capteur 5 et une ligne de liaison 8 tous deux recouverts d'une couche protectrice 19, est montrée figure 5. La couche protectrice 19 n'a pas besoin d'être beaucoup plus large que les conducteurs 5 et 8 qu'elle doit protéger. Elle est déposée au cours d'une deuxième opération d'impression sur les bandes conductrices déjà mises en place, aussitôt que ces dernières sont sèches; les deux couches sont ensuite cuites en une seule fois. Il est clair que, pour ne pas détruire leurs qualités respectives, il faut alors utiliser pour les fabriquer des compositions d'émail compatibles entre elles.

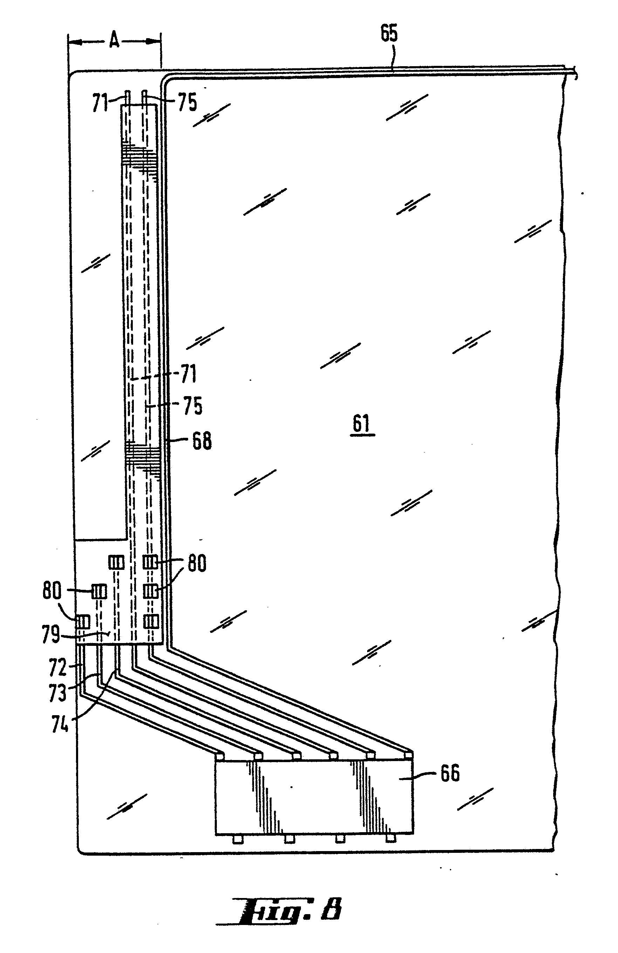

Les figures 6 et 7 montrent des détails d'une fenêtre d'automobile sur laquelle on n'a pas besoin d'un raccordement conducteur en direction de la carrosserie. La vitre 41 porte le long du bord vertical 47 une ligne de liaison 48 courant en direction du capteur, non visible, et des plages de contact 51, 52 raccordées à des lignes de commutation 53 et 54. A la place du raccordement à la carrosserie existe sur la vitre 41 une ligne auxiliaire 55 porteuse de plages de contact 51', 52' qu'un contact glissant au moins, le plot 56, disposé dans le cadre de la fenêtre (figure 7) peut connecter aux plages de contact 51, 52 donc aux lignes 53 et 54. Les plots glissants 56 sont, par exemple, constitué de graphite ou d'un matériau à base de graphite chargé d'argent, et encastrés dans le matériau élastique du profilé 57, porté lui-même par le montant 58 et qui sert à guider la vitre. Ces plots glissants 56 peuvent être rendus élastiques grâce à un choix convenable du matériau, ce qui évite d'avoir à les monter sur des ressorts de pression comme il le faudrait sans cela.

Une telle fenêtre recevra de préférence sur ses bandes conductrices une couche protectrice 59 qui, comme le montrent les figures 6 et 7, laisse à nu dans les fenêtres 60 les plages de contact 51, 51', 52, 52' de manière à ne pas empêcher les plots de les toucher.

Dans la version représentée figure 8, la vitre 61 porte un circuit intégré compact constituant un élément de commande 66 piloté d'une part par le capteur 65, auquel le relie une ligne de liaison 68 et d'autre part à partir des cinq autres lignes 71 à 75 de commutation. Ces lignes sont recouvertes d'une couche céramique isolante 79 qui, à son extrémité supérieure, laisse dépasser les conducteurs 71 et 75 et sur laquelle sont ménagées de place en place des fenêtres 80, grâce à quoi un contact glissant disposé dans le cadre de la fenêtre commute l'une après l'autre les lignes 71 à 74 à la ligne 75. La ligne 71 établit le contact de fin de course du moteur d'entraînement de la fenêtre en position d'ouverture complète tandis que la ligne 72 sert à l'établir en fin de fermeture. Le raccordement successif des lignes 73 et 74 permet de faire varier par degrés la sensibilité du circuit de détection, ce qui peut être avantageux quand on veut éliminer l'influence capacitive du cadre de la fenêtre sur le détecteur dans la phase finale de la fermeture pour que la fenêtre continue son mouvement de fermeture sans être influencée par ce cadre.

## Revendications

1. Fenêtre coulissante (1) mue électriquement et munie d'un dispositif de sécurité comprenant un circuit électronique dans lequel un conducteur (5) disposé le long du bord supérieur (2, 4) de la vitre constitue le capteur capacitif d'un étage de détection à oscillateur et commande un relais de coupure interrompant l'alimentation électrique du moteur au-delà d'un certain seuil d'amortissement, caractérisée en ce que, l'élément de circuit (6, 26, 66) comprenant l'étage de détection étant un élément compact, lui-même aussi bien que sa ligne de liaison (8, 28, 48, 68) avec le capteur (5, 25, 65) sont disposés à même la vitre qui porte ce dernier, et en position fixe l'un par rapport à l'autre.

2. Fenêtre coulissante selon la revendication 1, caractérisée en ce que la ligne de liaison entre le capteur et l'élément de circuit compact comprenant l'étage de détection est formée d'une bande conductrice imprimée à la surface du vitrage.

3. Fenêtre coulissante selon la revendication 2, caractérisée en ce que la ligne de liaison et le capteur sont constitués du même matériau, et simultanément déposés puis cuits et incorporés au vitrage par réchauffage de celui-ci.

4. Fenêtre coulissante selon l'une des revendications 1 à 3, caractérisée en ce que l'élément de circuit compact est un circuit intégré fixé au vitrage par enfichage, collage, ou soudage.

5. Fenêtre coulissante selon l'une des revendications 1 à 4, caractérisée en ce que la ligne de liaison aboutit, à l'intérieur ou au voisinage immédiat de la portion de la feuille de verre qui porte l'élément compact, à des plages de connexion (9, 29) élargies auxquelles ce dernier est raccordé.

6. Fenêtre coulissante selon l'une des revendications 1 à 5, caractérisée en ce que le circuit de commande est accordé en fonction de la capacité du capteur et de celle de la ligne de liaison.

7. Fenêtre coulissante selon l'une des revendications 2 à 6, caractérisée en ce que le capteur (5) et la ligne de liaison (8, 48, 68) sont revêtus d'une couche protectrice isolante (19, 59, 79) obtenue à partir d'une pâte céramique.

8. Fenêtre coulissante selon l'une des revendications 1 à 7, caractérisée en ce que d'autres lignes conductrices imprimées et cuites (13, 14, 33, 34, 53 à 55, 71 à 75) reliées à l'élément compact et servant à la commutation sont présentes en plus de la ligne de liaison.

9. Fenêtre coulissante selon une des revendications précédentes, caractérisée en ce que sur la vitre est imprimé un réseau chauffant (22) formé de conducteurs horizontaux (22a) débouchant sur des conducteurs latéraux (22b) eux-mêmes raccordés à l'élément de circuit (26) qui les alimente en courant.

## Claims

1. An electrically drivable sliding window (1) provided with a safety device comprising an electronic circuit in which a conductor (5) arranged along the upper edge (2, 4) of the pane constitutes the capacitative detector of an oscillator detection stage and controls an isolating relay interrupting electrical feed to a motor beyond a certain threshold of damping, characterised in that the circuit element (6, 26, 66) comprising the detection stage being a compact element, it and its connection line (8, 28, 48, 68) to the detector (5, 25, 65) are arranged on the pane itself which carries the latter and in a fixed position one relative to the other.

2. Sliding window according to claim 1, characterised in that the connection line between the detector and the compact circuit element comprising the detection stage is formed of a conducting strip printed on the pane surface.

3. Sliding window according to claim 2, characterised in that the connection line and the detector are formed of the same materials, and simultaneously deposited and then fired and incorporated with the pane by heating of the latter.

4. Sliding window according to one of claims 1 to 3, characterised in that the compact circuit element is an integrated circuit fixed to the pane by plugging in, adhesion or welding.

5. Sliding window according to one of claims 1 to 4, characterised in that the connection line leads, inside or in the immediate vicinity of the portion of the glass sheet which carries the compact element, to enlarged connection areas (9, 29) to which the latter is connected.

6. Sliding window according to one of claims 1 to 5, characterised in that the control circuit is tuned as a function of the capacity of the detector and that of the connection line.

7. Sliding window according to one of claims 2 to 6, characterised in that the detector (5) and the connection line (8, 48, 68) are covered by an insulating protective layer (19, 59, 79) obtained from a ceramic paste.

8. Sliding window according to one of claims 1 to 7, characterised in that other printed and fired conducting lines (13, 14, 33, 34, 53 to 55, 71 to 75) connected to the compact element and providing switching are present in addition to the connection line.

9. Sliding window according to one of the preceding claims, characterised in that there is printed on the pane a heating network (22) formed of horizontal conductors (22a) leading to lateral collectors (22b) themselves connected to the circuit element (26) which feeds them with current.

## Patentansprüche

1. Elektrisch verschiebbares Fenster (1) mit einer Sicherheitseinrichtung enthaltend eine elektronische Schaltung, in welcher ein längs des oberen Rands (2,4) der Fensterscheibe angeordneter Leiter (5) den kapazitiven Fühler eines Oszillator-Detektorkreises bildet und ein Schaltrelais steuert, welches bei Überschreitung eines Dämpfungsgrenzwertes die Stromzufuhr zum Fensterhebermotor unterbricht, dadurch gekennzeichnet, dass das Schaltelement (6, 26, 66), welches den Detektorkreis enthält und ein kompaktes Bauelement bildet, sowie seine Verbindungsleitung (8, 28, 48, 68) mit dem Fühler (5, 25, 65) unmittelbar auf der den Fühler tragenden Scheibe und in fester Zuordnung zueinander angeordnet sind.

2. Fenster nach Anspruch 1, dadurch gekennzeichnet, dass die Verbindungsleitung zwischen dem Fühler und dem den Detektorkreis enthaltenden kompakten Schaltelement durch ein auf die Glasoberfläche aufgedrucktes Leiterband gebildet ist.

3. Fenster nach Anspruch 2, dadurch gekennzeichnet, dass die Verbindungsleitung und der Fühler aus demselben Material bestehen und gleichzeitig auf die Glasscheibe aufgebracht und durch Erwärmung der Glasscheibe auf diese aufgeschmolzen bzw. eingebrannt und in diese integriert sind.

4. Fenster nach einem der Ansprüche 1 bis 3, dadurch gekennzeichnet, dass das kompakte Schaltelement eine integrierte Schaltung ist, welche durch eine Steck-, Klebe- oder Lötverbindung mit der Glasscheibe verbunden ist.

5. Fenster nach einem der Ansprüche 1 bis 4, dadurch gekennzeichnet, dass die Verbindungsleitung innerhalb oder unmittelbar neben dem das kompakte Schaltelement tragenden Teil der Glasscheibe mit einer verbreiterten Anschlusszone (9, 29) mündet, mit der die Steuerschaltung verbunden ist.

6. Fenster nach einem der Ansprüche 1 bis 5, dadurch gekennzeichnet, dass die Steuerschaltung entsprechend der Kapazität des Fühlers und der Verbindungsleitung abgeglichen ist.

7. Fenster nach einem der Ansprüche 2 bis 6, dadurch gekennzeichnet, dass der Fühler (5) und die Verbindungsleitung (8, 48, 68) mit einer isolierenden Schutzschicht (19, 59, 79) aus einer keramischen Masse versehen ist.

8. Fenster nach einem der Ansprüche 1 bis 7, dadurch gekennzeichnet, dass neben der Verbindungsleitung weitere aufgedruckte und eingebrannte elektrische Leitungen (13, 14, 33, 34, 53 - 55, 71 - 75) vorgesehen sind, die mit dem kompakten Schaltelement verbunden sind und zur Kommutation dienen.

9. Fenster nach einem der vorhergehenden Ansprüche, dadurch gekennzeichnet, dass auf die Glasscheibe ein Heizgitter (22) aufgedruckt ist, welches durch horizontale Leiter (22a) gebildet ist, die in seitlichen Kollektoren (22b) münden, die mit dem diese mit Strom versorgenden Schaltelement (26) verbunden sind.

**Fig. 1**

**Fig. 2**

Fig. 3

Fig. 4

Fig. 5

Fig. 7

Fig. 6

*Fig. 8*